Europäisches Patentamt

European Patent Office

Office européen des brevets

(11) Veröffentlichungsnummer : **0 008 406**
B1

# (12) EUROPÄISCHE PATENTSCHRIFT

(45) Veröffentlichungstag der Patentschrift :
26.01.83

(21) Anmeldenummer : 79102864.0

(22) Anmeldetag : 08.08.79

(51) Int. Cl.³ : **H 01 L 21/56**, H 01 L 23/28,
H 01 L 21/205

(54) Verfahren zum Herstellen einer Passivierungsschicht auf einem Silicium-Halbleiterkörper.

(30) Priorität : 23.08.78 DE 2836911

(43) Veröffentlichungstag der Anmeldung :
05.03.80 Patentblatt 80/05

(45) Bekanntmachung des Hinweises auf die Patenterteilung : 26.01.83 Patentblatt 83/04

(84) Benannte Vertragsstaaten :
FR GB IT

(56) Entgegenhaltungen :
DE B 1 185 896
FR A 2 345 810
FR A 2 371 524
US A 2 789 258
US A 4 134 125

(73) Patentinhaber : SIEMENS AKTIENGESELLSCHAFT
Berlin und München Wittelsbacherplatz 2
D-8000 München 2 (DE)

(72) Erfinder : Dannhäuser, Friedrich, Dr. Dipl.-Ing.
Freischützstrasse 17
D-8000 München 81 (DE)
Erfinder : Kempter, Karl, Dr.rer.nat., Dipl.-Phys.
Oppenriederstrasse 28a
D-8000 München 71 (DE)
Erfinder : Krausse, Jürgen, Dr., Dipl.-Phys.
Weidenstrasse 12
D-8011 Baldham (DE)
Erfinder : Schnöller, Manfred, Dr.rer.nat., Dipl.-Chem.
Grete-Hoffmann-Weg 24
D-8041 Haimhausen (DE)

# 0 008 406

Verfahren zum Herstellen einer Passivierungsschicht auf einem Silicium-Halbleiterkörper

Die Erfindung bezieht sich auf ein Verfahren zum Herstellen einer Passivierungsschicht aus amorphem Silicium auf einem Silicium-Halbleiterkörper.

Ein solches Verfahren ist beispielsweise in der DE-B-1 185 896 beschrieben worden. Bei diesem Verfahren wird das amorphe Silicium durch Aufdampfen im Vakuum aufgebracht. Angaben über die elektrischen Eigenschaften der dadurch erzeugten Passivierungsschicht lassen sich dem genannten Dokument nicht entnehmen.

Untersuchungen an aus amorphem Silicium bestehenden Passivierungsschichten haben ergeben, daß ein bestimmter Gehalt an Wasserstoff vorteilhafte Auswirkungen auf die elektrischen Eigenschaften einer solchen Passivierungsschicht hat.

Der Erfindung liegt die Aufgabe zugrunde, ein Verfahren der eingangs erwähnten Art so weiterzubilden, daß damit eine für die elektrischen Eigenschaften der Passivierungsschicht vorteilhafte Wasserstoffkonzentration auf einfache Weise eingestellt werden kann.

Diese Aufgabe wird dadurch gelöst, daß der Halbleiterkörper in ein eine Glimmentladungsstrecke enthaltendes Reaktionsgefäß gebracht wird, daß eine gasförmige Silicium-Wasserstoffverbindung in das Reaktionsgefäß eingeleitet und in einer Glimmentladung zersetzt wird, und daß während der Glimmentladung der Druck und die Strömungsgeschwindigkeit der Gasförmigen Silicium-Wasserstoffverbindung sowie die Leistung der Glimmentladung und die Temperatur des Halbleiterkörpers so eingestellt werden, daß auf dem Halbleiterkörper eine amorphe Siliciumschicht mit einem die Höhe ihres spezifischen Widerstandes bestimmenden Gehalt zwischen 5 und 40 Atomprozent an Wasserstoff abgeschieden wird.

In der FR-A-2 345 810 ist zwar bereits ein Verfahren zum Aufbringen von amorphem Silicium durch eine Glimmentladung beschrieben worden. Dieses amorphe Silicium enthält auch etwas Wasserstoff, allerdings in einer nicht näher angegebenen Konzentration. Die aufgebrachte amorphe Siliciumschicht dient jedoch nicht zum Passivieren, sondern dazu, einen guten Kontakt zu einer das Halbleiterbauelement bedeckenden Metallschicht herzustellen.

Neben dem Vorteil des erfindungsgemäßen Verfahrens, den Wasserstoffgehalt genau einstellen zu können entfallen auch die Nachteile von Aufdampfverfahren, bei denen die Beschichtungsdicke vom Winkel zwischen der Substratoberfläche und der zu beschichtenden Fläche abhängt. Außerdem entfallen die bei Bedampfungsverfahren nie ganz vermeidbaren Abschattungseffekte.

Weiterbildungen der Erfindung sind Gegenstand der Unteransprüche.

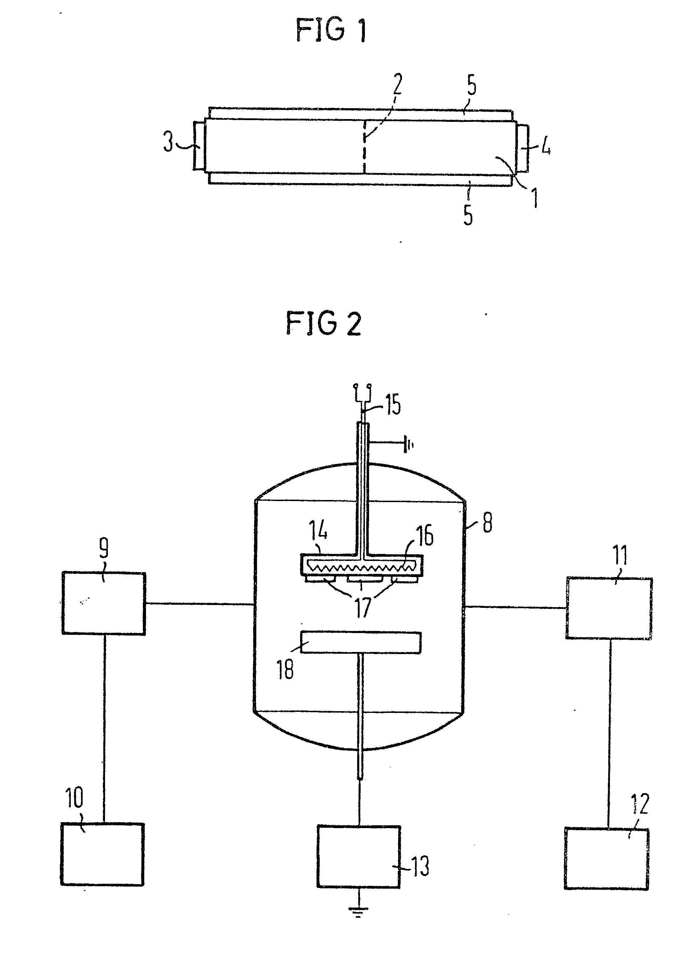

Die Erdinfung wird an Hand eines Ausführungsbeispiels in Verbindung mit den Fig. 1 und 2 erläutert. Es zeigen :

Figur 1   den Schnitt durch einen Halbleiterkörper mit Passivierungsschicht und

Figur 2   eine Anordnung zum Aufbringen einer Passivierungsschicht durch Glimmentladung.

Der Halbleiterkörper nach Fig. 1 ist mit 1 bezeichnet. Er besteht aus Silicium und ist mit einem pn-Übergang 2 versehen, der bis an die Oberfläche des Halbleiterkörpers 1 tritt. Am Halbleiterkörper sind Elektroden 3, 4 angebracht. Der Rand des Halbleiterkörpers 1 ist mit einer Passivierungsschicht 5 aus amorphem, durch Glimmentladung aufgebrachten Silicium bedeckt. Die Passivierungsschicht 5 kann zum Beispiel 0,2 μm dick sein. Bei integrierten Schaltungen kann die Dicke auch darunter liegen. Es hat sich herausgestellt, daß die amorphe Siliciumschicht dann besonders als Passivierungsschicht geeignet ist, wenn ihr spezifischer Widerstand zwischen $10^8$ und $10^{10}$ Ohm · cm liegt. Dieser spezifische Widerstand wird durch die Höhe des Wasserstoffgehalts im amorphen Silicium bestimmt. Dabei gilt allgemein, daß der spezifische Widerstand um so höher wird, je höher der Wasserstoffgehalt ist. Für hochsperrende Halbleiterbauelemente kann sich ein noch höherer spezifischer Widerstand empfehlen, zum Beispiel bis $5 \cdot 10^{11}$ Ohm · cm. Diese Widerstandserhöhung läßt sich durch Zugabe von Dotierstoffen, wie zum Beispiel Bor oder Kohlenstoff, erreichen.

Die Wasserstoff enthaltende Passivierungsschicht 5 aus amorphem Silicium kann durch die in Fig. 2 dargestellte Anlage aufgebracht werden. In einem Behälter 8 sind zwei Elektroden 14, 18 untergebracht, die mit den Ausgangsklemmen eines Spannungsgenerators 13 verbunden sind. An der Elektrode 14 sind aus Silicium bestehende Halbleiterkörper 17 befestigt. Diese Halbleiterkörper können einen, zwei oder mehrere pn-Übergänge enthalten oder auch integrierte Schaltungen sein. Die Elektrode 14 ist mit einem Heizer 16 versehen, der über Heizleitungen 15 mit einer Spannungsquelle verbunden ist. Mit dem Heizer 16 können die Halbleiterkörper 17 aufgeheizt werden. Die Halbleiterkörper können auch an der Elektrode 18 befestigt sein, die aufgeheizt werden kann. Der Behälter 8 ist mit einem Pumpstand 12 verbunden, dem noch ein Partikelabscheider 11 vorgeschaltet sein kann. Weiter ist der Behälter 8 über einen Druckregler 9 mit einer Gasquelle 10 verbunden. Die Gasquelle 10 liefert die Silicium-Wasserstoffverbindung, zum Beispiel Silan $SiH_4$ und ein Trägergas, beispielsweise Argon. Der Silicium-Wasserstoffverbindung können in der Gasquelle 10 Dotiergase beigemischt werden.

Vor Beginn des Abscheidevorgangs wird der Behälter 8 vom Pumpstand 12 evakuiert und ein Silandruck von 0,01 mbar bis 2 mbar, vorzugsweise von 0,2 bis 0,6 mbar, eingestellt. Die Halbleiterkörper 17 werden auf eine Temperatur, die zwischen Zimmertemperatur und 350 °C liegt, aufgeheizt. Vorzugsweise wird eine Temperatur zwischen 150 und 250 °C angewandt. Durch Anlegen einer elektrischen Spannung zwischen die Elektroden 14, 18 wird eine Glimmentladung betrieben, bei der Beispielsweise eine Leistung bis 1 W/cm$^2$ Oberfläche der Halbleiterkörper umgesetzt wird. Die angelegte Spannung kann eine Gleichspannung, eine niederfrequente oder auch eine hochfrequente Wechselspannung mit einer Frequenz von zum Beispiel 27 MHz sein. Unter den angegebenen Bedingungen scheidet sich auf der Oberfläche der Halbleiterkörper 17 eine amorphe Siliciumschicht ab, die 5 bis 40 Atomprozent Wasserstoff enthält. Wenn die Glimmentladung für einige zehn Minuten aufrechterhalten wird, hat sich eine Passivierungsschicht von einigen 0,1 μm Stärke auf der Oberfläche der Halbleiterkörper niedergeschlagen. Durch den Wasserstoff tritt eine Absättigung von elektronischen Zuständen im amorphen Silicium ein. Dies führt einmal zu einer Stabilisierung des elektrischen Widerstandes gegenüber äußeren Einflüssen und zum anderen durch die einstellbare Menge des eingebauten Wasserstoffs zu einem Wert des spezifischen elektrischen Widerstandes von $10^8$ Ohm · cm bis $10^{10}$ Ohm · cm, wie er für die Passivierung als optimal bekannt ist.

Der Wasserstoffgehalt, der für die Höhe und Stabilität des spezifischen Widerstandes der Passivierungsschicht von Bedeutung ist, kann durch Änderungen der Parameter Silandruck, Silanströmungsgeschwindigkeit, Leistung der Glimmentladung und Substrattemperatur (Temperatur der Halbleiterkörper) eingestellt werden. Zur Einstellung des spezifischen Widerstandes auf noch höhere spezifische Widerstände können dem im Gefäß 8 befindlichen Plasma zusammen mit dem Silan Dotiergase zugesetzt werden. So ist es einfach möglich, den spezifischen elektrischen Widerstand durch Dotierung oder veränderte chemische Zusammensetzung des amorphen Siliciums auf die sehr hohen Werte von $10^9$ Ohm · cm bis $10^{11}$ Ohm · cm einzustellen. Dadurch kann der am pn-Übergang auftretende elektrische Nebenschluß bei Bedarf noch wirksamer unterdrückt werden. Eine Zumischung von $10^{-4}$ bis $10^{-2}$ Volumenprozent Diboran ($B_2H_6$) zum siliciumhaltigen Reaktionsgas erhöht den spezifischen elektrischen Widerstand auf bis zu $5 \cdot 10^{11}$ Ohm · cm. Mischt man das Reaktionsgas Silan mit nahezu 50 % Äthylen ($C_2H_4$), so erhält man ein dem Siliciumcarbid ähnliches amorphes Material, dessen spezifischer Widerstand ebenfalls zwischen $10^{10}$ und $10^{11}$ Ohm · cm liegt.

Ein besonderer technischer Vorteil des vorgeschlagenen Verfahrens ist in der relativ niedrigen, zur Reaktion notwendigen Temperatur von ca. 200 °C begründet. Die zur Zersetzung des silanhaltigen Reaktionsgases notwendige Energie wird durch das Glimmentladungsplasma und nicht wie zum Beispiel beim sogenannten CVD-Verfahren (Chemical Vapor Deposition) durch die Temperatur bereitgestellt. Dies bedeutet eine für die Praxis oft sehr wichtige Schonung des zu passivierenden Halbleiterbauelements. Durch den eingebauten Wasserstoff und die eventuell eingebauten Dotierstoffe erhält die amorphe Siliciumschicht gleich beim Niederschlag die notwendige elektronische Zustanddichteverteilung und damit den optimalen spezifischen elektrischen Widerstand, so daß sich eine nachträgliche Wärmebehandlung, wie bei Aufdampfschichten notwendig, bei dem hier vorgeschlagenen Verfahren erübrigt.

Man erhält nach dem beschriebenen Verfahren Passivierungsschichten auf Halbleiterbauelementen, die eine hervorragende Haftfestigkeit aufweisen und eine völlige Stabilität gegenüber Feuchteeinflüssen zeigen. Nach einer Wärmebehandlung bis zu 500 °C, wie sie bei manchen nachträglichen Behandlungsschritten des Halbleiterbauelements erforderlich sind (zum Beispiel Löten), treten nur unwesentliche Änderungen des spezifischen Widerstandes auf.

Für die technische Anwendung weiterhin entscheidend ist, daß die wasserstoffhaltigen amorphen Siliciumschichten in üblicher Weise, zum Beispiel durch Kalilauge, ätzbar sind.

<div align="center">Ausführungsbeispiele :</div>

| | |
|---|---|
| Reaktionsgas : | $SiH_4$ |
| Gasdruck : | 0,22 mbar |
| Strömungsgeschwindigkeit : | 10 mMol/h bei 10 l Reaktorvolumen |
| Substrattemperatur : | 230 °C |
| Glimmentladungsleistung bezogen auf Elektrodenfläche : | 7 mW/cm$^2$ |
| Reaktionszeit : | 20 min |
| Schichtdicke : | 0,2 μm |
| Wasserstoffgehalt : | 15 % |
| Spezifischer Widerstand : | $1,2 \cdot 10^9$ Ohm · cm |

Bei einer Substrattemperatur von 250 °C wurde bei sonst gleichen Bedingungen ein Wasserstoffgehalt von 11 % und ein spezifischer Widerstand von $5 \cdot 10^8$ Ohm · cm erhalten.

**Ansprüche**

1. Verfahren zum Herstellen einer Passivierungsschicht (5) aus amorphem Silicium auf einem Silicium-Halbleiterkörper (1 ; 17), dadurch gekennzeichnet, daß der Halbleiterkörper (17) in ein eine Glimmentladungsstrecke enthaltendes Reaktionsgefäß (8) gebracht wird, daß eine gasförmige Silicium-Wasserstoffverbindung in das Reaktionsgefäß (8) eingeleitet und in einer Glimmentladung zersetzt wird, und daß während der Glimmentladung der Druck und die Strömungsgeschwindigkeit der gasförmigen Silicium-Wasserstoffverbindung sowie die Leistung der Glimmentladung und die Temperatur des

0 008 406

Halbleiterkörpers (17) so eingestellt werden, daß auf dem Halbleiterkörper eine amorphe Siliciumschicht mit einem die Höhe ihres spezifischen Widerstandes bestimmenden Gehalt zwischen 5 und 40 Atomprozent an Wasserstoff abgeschieden wird.

2. Verfahren nach Anspruch 1, dadurch gekennzeichnet, daß als gasförmige Verbindung Silan $SiH_4$ verwendet wird.

3. Verfahren nach Anspruch 2, dadurch gekennzeichnet, daß dem Silan $1 \cdot 10^{-4}$ bis $1 \cdot 10^{-2}$ Volumenprozent Diboran ($B_2H_6$) beigemischt wird.

4. Verfahren nach Anspruch 2, dadurch gekennzeichnet, daß dem Silan 10 bis 60 Volumenprozent Äthylen ($C_2H_4$) beigemischt wird.

5. Verfahren nach einem der Ansprüche 1 bis 4, dadurch gekennzeichnet, daß der Halbleiterkörper (17) auf eine Temperatur zwischen Zimmertemperatur und 350 °C aufgeheizt wird.

6. Verfahren nach Anspruch 5, dadurch gekennzeichnet, daß der Halbleiterkörper (17) auf eine Temperatur zwischen 150 und 250 °C aufgeheizt wird.

7. Verfahren nach einem der Ansprüche 1 bis 4, dadurch gekennzeichnet, daß ein Silandruck zwischen 0,01 mbar und 2 mbar eingestellt wird.

8. Verfahren nach Anspruch 7, dadurch gekennzeichnet, daß ein Silandruck zwischen 0,2 und 0,6 mbar eingestellt wird.

9. Verfahren nach einem der Ansprüche 1 bis 8, dadurch gekennzeichnet, daß der spezifische Widerstand des amorphen Siliciums zu $10^8$ bis $5 \cdot 10^{11}$ Ohm · cm eingestellt wird.


### Claims

1. A process for the production of a passivation layer (5) consisting of amorphous silicon on a silicon semiconductor body (1 ; 17), characterised in that the semiconductor body (17) is introduced into a reaction vessel (8) containing a glow discharge section ; that a gaseous silicon-hydrogen compound is led into the reaction wessel (8) and decomposed in a glow discharge ; and that during the glow discharge, the pressure and the flow rate of the gaseous silicon-hydrogen compound, as well as the power of the glow discharge and the temperature of the semiconductor body (17), are so adjusted that an amorphous silicon layer having a hydrogen content of between 5 and 40 atom percent, which content determines the value of the specific resistance of the amorphous silicon layer, is deposited on the semiconductor body.

2. A process as claimed in Claim 1, characterised in that silane $SiH_4$ is used as the gaseous compound.

3. A process as claimed in Claim 2, characterised in that $1 \cdot 10^{-4}$ to $1 \cdot 10^{-2}$ percent by volume of diborane ($B_2H_6$) is added to the silane.

4. A process as claimed in Claim 2, characterised in that 10 to 60 percent by volume of ethylene ($C_2H_4$) is added to the silane.

5. A process as claimed in one of Claims 1 to 4, characterised in that the semiconductor body (17) is heated to a temperature between room temperature and 350 °C.

6. A process as claimed in Claim 5, characterised in that the semiconductor body (17) is heated to a temperature of between 150 and 250 °C.

7. A process as claimed in one of Claims 1 to 4, characterised in that a silane pressure of between 0.01 and 2 mbar is set.

8. A process as claimed in Claim 7, characterised in that a silane pressure of between 0.2 and 0.6 mbar is set.

9. A process as claimed in one of Claims 1 to 8, characterised in that the specific resistance of the amorphous silicon is set at $10^8$ to $5 \cdot 10^{11}$ Ohm · cm.


### Revendications

1. Procédé pour réaliser une couche de passivation (5) en silicium amorphe sur un corps semiconducteur en silicium (1 ; 17), caractérisé par le fait que le corps semiconducteur (17) est introduit dans un réacteur (8) contenant une voie de décharge électrique par effluve, qu'un composé gazeux silicium-hydrogène est introduit dans le réacteur (8) et est décomposé par une décharge électrique par effluve, et que pendant l'effluve électrique la pression et la vitesse d'écoulement du composé gazeux silicium-hydrogène, de même que la puissance de l'effluve et la température du corps semiconducteur (17) sont ajustées de telle manière que se dépose sur le corps semiconducteur une couche de silicium amorphe avec une teneur entre 5 et 40 % en atome d'hydrogène, qui détermine la valeur de la résistance spécifique de cette couche.

2. Procédé selon la revendication 1, caractérisé par le fait que l'on utilise, comme composé gazeux du silane $SiH_4$.

3. Procédé selon la revendication 2, caractérisé par le fait qu'au silane on mélange $1 \cdot 10^{-4}$ à $1 \cdot 10^{-2}$ % en volume de diborane ($B_2H_6$).

4. Procédé selon la revendication 2, caractérisé par le fait qu'on mélange au silane 10 à 60 % en

4

volume d'éthylène ($C_2H_4$).

5. Procédé selon l'une des revendidations 1 à 4, caractérisé par le fait que le corps semiconducteur (17) est chauffé à une température entre la température ambiante et 350 °C.

6. Procédé selon la revendication 5, caractérisé par le fait que le corps semiconducteur (17) est chauffé à une température entre 150 et 250 °C.

7. Procédé selon l'une des revendications 1 à 4, caractérisé par le fait que l'on règle une pression de silane entre 0,01 mbar et 2 mbar.

8. Procédé selon la revendication 7, caractérisé par le fait qu'on règle une pression de silane entre 0,2 et 0,6 mbar.

9. Procédé selon l'une des revendications 1 à 8, caractérisé par le fait que la résistance spécifique du silicium amorphe est réglée à $10^8$ à $5 \cdot 10^{11}$ Ohm $\cdot$ cm.

# FIG 1

# FIG 2